Europäisches Patentamt

European Patent Office

Office européen des brevets

(11) Numéro de publication: **0 077 862**
**B1**

(12) # FASCICULE DE BREVET EUROPEEN

(45) Date de publication du fascicule du brevet: **26.02.86**

(51) Int. Cl.⁴: **H 01 L 21/66, G 01 R 31/26**

(21) Numéro de dépôt: **81430036.4**

(22) Date de dépôt: **28.10.81**

(54) Procédé de caractérisation du comportement en fiabilité de dispositifs semi-conducteurs bipolaires.

(43) Date de publication de la demande:
**04.05.83 Bulletin 83/18**

(45) Mention de la délivrance du brevet:
**26.02.86 Bulletin 86/9**

(84) Etats contractants désignés:
**DE FR GB**

(56) Documents cités:
IEEE TRANSACTIONS ON PARTS, HYBRIDS AND PACKAGING, Vol. PHP-13, No. 4 décembre 1977 New York D.J. LaCOMBE et al. "A Study of the Reliability of Microwave Transistors" pages 354 à 361
IEEE PROCEEDINGS-I, Vol. 128, No. 2 Part I, avril 1981 Old Woking W.V. BACKENSTO et al. "Measurement of Interface State Characteristics of MOS Transistor Utilising Charge-Pumping Techniques" pages 44 à 52

(73) Titulaire: **International Business Machines Corporation, Old Orchard Road, Armonk, N.Y. 10504 (US)**

(84) Etats contractants désignés: **DE GB**

(73) Titulaire: **Compagnie IBM FRANCE, 5 Place Vendôme, F-75000 Paris 1er (FR)**

(84) Etats contractants désignés: **FR**

(72) Inventeur: **Tremintin, Bernard, 4 rue Salmon, F-91100 Corbeil Essonnes (FR)**

(74) Mandataire: **Klein, Daniel Jacques Henri, Compagnie IBM France Département de Propriété Industrielle, F-06610 La Gaude (FR)**

EP 0 077 862 B1

# 0 077 862

**Description**

La présente invention concerne le domaine des circuits intégrés à semi-conducteurs et plus particulièrement un procédé de caractérisation du comportement en fiabilité de dispositifs semi-conducteurs bipolaires, fabriqués sur une ligne déterminée et à l'aide d'une technologie déterminée, selon la première partie de la revendication 1.

Schématiquement, les microplaquettes de silicium présentent, une fois le cycle complet de fabrication achevé, deux types de défauts. D'abord des défauts immédiats qui peuvent être détectés, lors des différentes caractérisations ou lors du test électrique final: par exemple une coupure dans un conducteur métallique, ou une région base court-circuitée par un défaut de conduit. Ensuite, d'autres défauts, potentiels qui ne peuvent être détectés qu'ultérieurement après un certain temps de fonctionnement. Par exemple, le phénomène bien connu de l'électromigration des grains d'aluminium dans les conducteurs en aluminium, qui provoque, par l'accumulation de ces grains, l'éclatement de la couche de silice de recouvrement. Le problème de l'électromigration a reçu une solution élégante avec l'emploi d'une métalurgie aluminium-cuivre, on pourra notamment se référer au document US—A—3 725 309 (IBM). Les défauts de ce dernier type sont dits de fiabilité et ils sont souvent catastrophiques car ils nécessitent des interventions dans des machines installées en clientèle avec tous les inconvénients que cela comporte.

Parmi les défauts de fiabilité, ceux résultant des instabilités dans l'oxyde de passivation sont peu connus. Ces instabilités sont pourtant une cause importante des défauts en fiabilité des dispositifs semi-conducteurs bipolaires. Ils se manifestent sous la forme d'un courant de fuite qui se produit entre deux régions de type P, dans une couche épitaxiale de type N. Malheureusement, cette structure parasite PNP qui se retrouve très fréquemment dans les dispositifs bipolaires (notamment entre la région base et la région d'isolation), est une cause non négligeable de défauts de fiabilité.

Le but des études de fiabilité est donc d'accélérer le murissement de ces défauts potentiels qui se dégradent avec le temps, et de les mettre en évidence avant la commercialisation des microplaquettes.

Pour cela, de façon connue les microplaquettes issues de fabrication sont fixées sur des substrats céramiques pour constituer des modules électroniques. Ces modules sont montés à leur tour sur des cartes qui comportent d'autres circuits annexes et assurent les fonctions de mesure d'un certain nombre de paramètres. Les cartes sont mises "sous contraintes", c'est-à-dire qu'elles sont introduites dans une étuve pendant qu'on leur applique des tensions, qui peuvent être les différentes tensions nominales de fonctionnement desdits modules (c'est le procédé dit de "burn in"). La température de l'étuve et la durée de l'opération sont fonction de la nature des microplaquettes. Des durées d'étuvage de l'ordre de 1000 heures (trois semaines) sont tout à fait normales. A intervalle de temps déterminé (toutes les 24 heures par exemple) un groupe de modules est extrait, et on vérifie son état de fonctionnement, on définit le temps de défaillance T (time to fail) comme le temps mis pour qu'une panne se produise. Si par exemple après 500 heures d'étuvage, on a 50% des modules qui sont défaillants on dira que le $T_{50}$ est de 500 heures.

Cette façon de procéder est lente (l'information est disponible après des jours ou même des semaines) et fastidieuse (nécessité de monter les microplaquettes sur un module et de créer, des cartes de support spéciales pour une application donnée, et inutilisables pour d'autres).

Le temps de réaction est long et donc la correction du défaut est tardive, en conséquence une quantité considérable de microplaquettes défectueuses (et donc inutilisables) peut avoir été fabriqué ce qui augmente les coûts de production.

L'industrie des semi-conducteurs a donc besoin d'un procédé de caractérisation de la fiabilité des dispositifs bipolaires qui de préférence s'effectue au niveau de la microplaquette et non plus au niveau du module, et qui évite de recourir à l'étape d'étuvage (qui implique la génération de cartes spéciales et des délais extrêmement longs).

La présente invention telle qu'elle est caractérisée dans la revendication 1 se propose de résoudre ce problème, en établissant expérimentalement une corrélation entre certains paramètres dits prépondérants parmi les paramètres électriques caractérisant les charges dans l'oxyde, regroupés dans une fonction fiabilité R, et les résultats en fiabilité fournis sous la forme d'un temps de défaillance par exemple le $T_{50}$. Cette étude expérimentale ayant mis, en évidence que ces phénomènes d'instabilité provenaient essentiellement de deux, parmi les nombreux paramètres physiques et électriques, qui caractérisent l'oxyde de passivation, à savoir le nombre de charges dans l'oxyde et la densité d'états d'interface.

Ces deux paramètres prépondérants qui interviennent dans la fonction R sont mesurés, en fin du procédé semi-conducteur, au niveau de la microplaquette sur une structure de test de type IGFET (transistor à effet de champ à porte isolée).

La structure de test, et c'est un des avantages de l'invention, est constituée simplement, à partir d'un transistor PNP parasite, tel qu'il a été mentionné ci-dessus, et qui a été utilisé en transistor FET, la région d'isolation, faisant office de source, la région base, de drain et le contact base, faisant office d'électrode de porte (elle est reliée au drain).

Le procédé de la présente invention qui fournit une détermination directe et rapide du temps de défaillance (par exemple le $T_{50}$), par de simples mesures électriques, comporte d'abord des étapes préliminaires d'étalonnage de la ligne de fabrication en cause. Ces étapes consistent dans: l'élaboration sur ladite ligne de fabrication, de dispositifs semi-conducteurs bipolaires comportant au moins une structure de test de type FET; la sélection d'une pluralité de ces dispositifs; le calcul pour chacun des dispositifs

2

# 0 077 862

·sélectés, à partir de la structure de test, d'une fonction fiabilité R égale au produit $N_{SS} \cdot N_{eff} \cdot N_D^{1/2}$ dans lequel $N_{SS}$ est la densité de charges d'interface, $N_{eff}$ la charge équivalente de l'oxyde et $N_D$ la concentration de la couche épitaxiale; la détermination pour ces dispositifs du temps de défaillance T (par exemple le $T_{50}$) et l'élaboration d'une courbe R=f(T) (par exemple R=f($T_{50}$)); et, une étape finale qui consiste au calcul pour tout autre dispositif issu de la ligne de fabrication de sa fonction R et la détermination directe de son temps de défaillance, (par exemple le $T_{50}$, prévisible à l'aide de la courbe R=f($T_{50}$)).

La fonction fiabilité R donnée ci-dessus peut être simplifiée et s'écrire $R'=N_{SS} \cdot N_{eff}$, en première approximation.

L'invention sera expliquée ci-après de façon plus détaillée à l'aide d'exemples de réalisation et en regard des dessins sur lesquels:

La figure 1A représente la structure d'un transistor bipolaire NPN classique qui met en évidence la présence d'un transistor PNP parasite entre la région d'isolation et la région base.

La figure 1B représente la même structure mais avec une métallisation différente qui permet de réaliser un transistor FET à canal P qui constitue la structure de test.

La figure 2A représente la variation de la fonction fiabilité R en fonction du temps de défaillance $T_{50}$ en heures, quand $R=N_{SS} \cdot N_{eff} \cdot N_D^{1/2}$, ($N_{SS}$ est la densité des charges d'interface, $N_{eff}$ est la charge équivalente de l'oxyde et $N_D$ la concentration en atomes/cm$^3$ de la couche épitaxiale.

La figure 2B représente les variations de la fonction fiabilité R' en fonction du temps de défaillance $T_{50}$ en heures quand $R'=N_{SS} \cdot N_{eff}$.

La figure 3 représente les courbes $E_{ox}=I(N_D)$ et $N_D=H(E_{ox})$ où $E_{ox}$ est l'épaisseur de la couche d'oxyde de passivation donnée en nanomètre.

La figure 4 représente le bloc diagramme de calcul des paramètres prépondérants de la fonction fiabilité R dans une application informatisée.

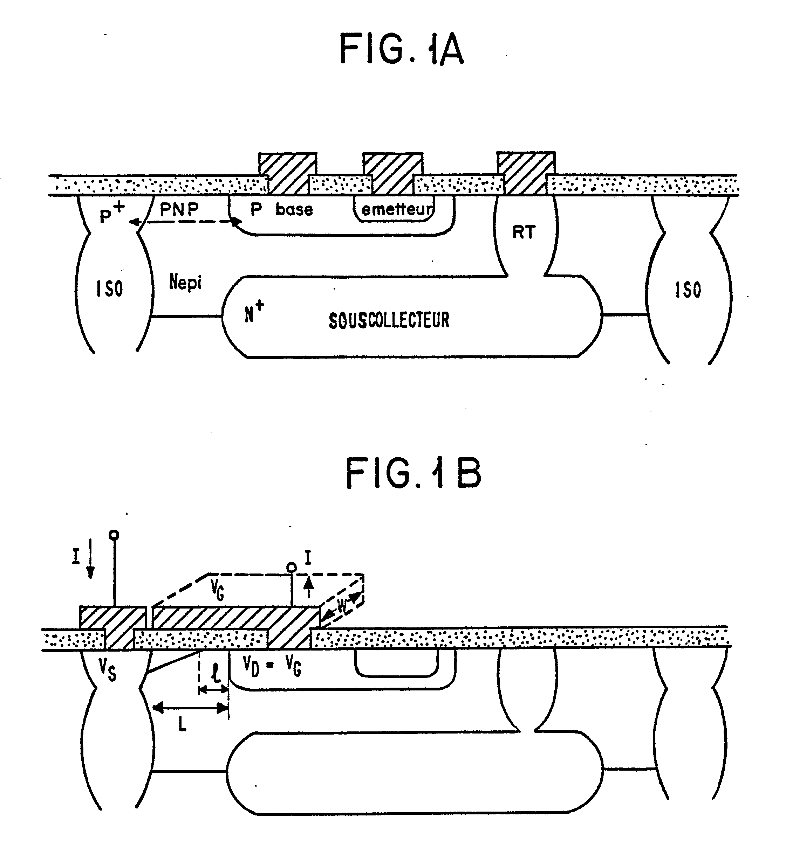

Sur la figure 1A on a représente un transistor bipolaire NPN classique comportant des régions émetteur, base et collecteur, des régions de sous-collecteur et de traversée de collecteur, formées dans un caisson isolé de la couche épitaxiale par des régions d'isolation. Comme on l'a mentionné ci-dessus, le défaut en fiabilité résulte d'un courant de fuite qui s'établit dans le transistor parasite, entre les deux régions de type P. Diverses observations ont mis en évidence que ce courant de fuite avait pour cause des instabilités dans la charge de l'oxyde de passivation. Pour comprendre le phénomène d'instabilités dans les charges d'oxyde, on a procédé d'abord à une étude théorique du·phénomène et à la mise en évidence de tous les paramètres intervenants dans ce phénomène d'instabilité (c'est l'objet de la partie I), puis par une étude empirique et systèmatique, on a établi une corrélation entre certains de ces paramètres considérés comme prépondérants, avec le temps de défaillance T (par exemple le $T_{50}$), c'est l'objet de la partie II qui constitue en fait le procédé de caractérisation de la présente invention. Dans la partie III de cet exposé, on donne le mode de calcul de ces paramètres prépondérants. Enfin la mise en oeuvre industrielle du procédé de caractérisation est décrite dans la partie IV.

I. Etude Théorique du Phénomène d'Instabilité

Pratiquement on peut toujours trouver une structure FET telle que celle représentée sur la figure 1B. Si ce n'était pas le cas, il suffit de modifier les masques: gravure des fenêtres dans l'oxyde et gravure du métal d'interconnexion, pour l'obtenir, et passer d'un transistor NPN bipolaire à un transistor FET à canal P.

On utilise donc un transistor FET, dont la région source est constituée par la région d'isolation supérieure et le drain par la région base du transistor NPN; la surface de la couche épitaxiale située entre ces régions forme la région de canal. La métallisation assure que $V_G=V_D$. En tout état de cause le transistor FET représenté sur la figure 1B, constitue la structure de test. La seule contrainte est que la tension de seuil $V_T$ du FET doit être inférieure à la tension de claquage de la jonction, pour rendre les mesures possibles.

Pour obtenir une caractérisation complète de l'oxyde, il a fallu d'abord comprendre la nature des différentes charges en présence.

Le courant de fuite qui apparaît entre les deux régions P semble résulter de la présence de charges induites à la surface du silicium. C'est-à-dire qu'il peut être crée par des charges mobiles dans l'oxyde ou par une injection de porteurs à partir du silicium. Une charge négative est cependant nécessaire à l'interface Si—$SiO_2$ pour créer un chemin conducteur dans le silicium.

Une telle condition peut se produire quand on a des ions mobiles négatifs dans l'oxyde qui peuvent dériver vers l'interface durant l'étuvage; des ions négatifs immobiles, neutralisés par des ions mobiles positifs, qui peuvent dériver à partir de l'interface laissant en place une charge négative, une injection d'électrons du silicium vers l'oxyde et le piégeage des électrons dans l'oxyde.

Différentes expérimentations ont mis en évidence que le phénomène d'inversion de la région N (qui crée le courant de fuite), ne résidait pas dans le déplacement des charges mobiles positives ou négatives. On a alors démontré qu'une injection d'électrons du silicium dans l'oxyde se produisait pendant l'étuvage et que ces électrons lorsqu'ils étaient piégés près de l'interface, étaient essentiellement responsables du courant de fuite.

On a donc finalement conclu que le courant de fuite ne dépendait pas des paramètres physiques de l'oxyde (densité, qualité, etc.) mais de certains paramètres électriques $N_{eff}$ (densité de charges dans l'oxyde), $N_{SS}$ (densité d'états d'interface) et, $N_D$ (concentration de la couche épitaxiale), ci-après dénommés paramètres prépondérants qui seuls caractérisaient à la fois le courant électronique qui se produit lors de

3

l'étuvage (composé du courant de diffusion, du courant de recombinaison à l'interface, du courant d'émission d'électrons du silicium vers l'oxyde crée par émission électronique et par effet tunnel) et le piégeage des électrons dans l'oxyde (fonction du nombre de piéges, etc.).

## II. Etablissement d'une Corrélation

Aucune corrélation entre chacun de ces trois paramètres $N_{eff}$, $N_{SS}$ et $N_D$ qui caractérisent le courant de fuite et les résultats de fiabilité n'a pu être trouvée. Après une étude systématique, effectuée en comparant les données du traitement d'étuvage et les résultats de caractérisation du FET, une très bonne corrélation a cependant pu être trouvée entre le temps de défaillance T (par exemple le $T_{50}$) et le produit de la densité d'états d'interface $N_{SS}$, de la densité de charges de l'oxyde $N_{eff}$ et la racine carrée de la concentration de la couche épitaxiale $N_D$. Pour cinq lots différents de tranches, numérotés A à E, on a mesuré tout d'abord les paramètres $N_D$, $N_{eff}$ et $N_{SS}$ à l'aide d'un mode de calcul qui sera détaillé dans la partie III de la description et on a rassemblé les résultats dans la table ci-dessous:

| Lot No. | $N_D$ $Cm^{-3}$ | $E_{ox}$ nm | $N_{eff}$ $cm^{-2}$ | $N_{ss}$ $eV^{-1}$ $cm^{-2}$ |
|---|---|---|---|---|
| A | $1,1 \times 10^{16}$ | 760 | $2,5 \times 10^{11}$ | $1,55 \times 10^{11}$ |
|   | $1,1 \times 10^{16}$ | 685 | $2,4 \times 10^{11}$ | $1,1 \times 10^{11}$ |
|   | $9,2 \times 10^{15}$ | 790 | $2,1 \times 10^{11}$ | $6,5 \times 10^{10}$ |
|   | $8,5 \times 10^{10}$ | 770 | $2,15 \times 10^{11}$ | $9,3 \times 10^{10}$ |
| B | $1,1 \times 10^{16}$ | 650 | $2,6 \times 10^{11}$ | $1,1 \times 10^{11}$ |
|   | $1,4 \times 10^{16}$ | 560 | $3,3 \times 10^{11}$ | $1,2 \times 10^{11}$ |
| C | $1,5 \times 10^{16}$ | 710 | $1,7 \times 10^{11}$ | $7,2 \times 10^{10}$ |
|   | $1,45 \times 10^{16}$ | 735 | $1,6 \times 10^{11}$ | $6,7 \times 10^{10}$ |
|   | $1,55 \times 10^{16}$ | 690 | $2 \times 10^{11}$ | $6,5 \times 10^{10}$ |
| D | $1,15 \times 10^{16}$ | 595 | $2,7 \times 10^{11}$ | $7,9 \times 10^{10}$ |
| E | $6,6 \times 10^{15}$ | 880 | $1,8 \times 10^{11}$ | $6,5 \times 10^{10}$ |
|   | $7,6 \times 10^{15}$ | 910 | $1,7 \times 10^{11}$ | $8,1 \times 10^{10}$ |
|   | $7,4 \times 10^{15}$ | 815 | $2,2 \times 10^{11}$ | $7,7 \times 10^{10}$ |
|   | $8,6 \times 10^{15}$ | 740 | $1,9 \times 10^{11}$ | $6,9 \times 10^{10}$ |

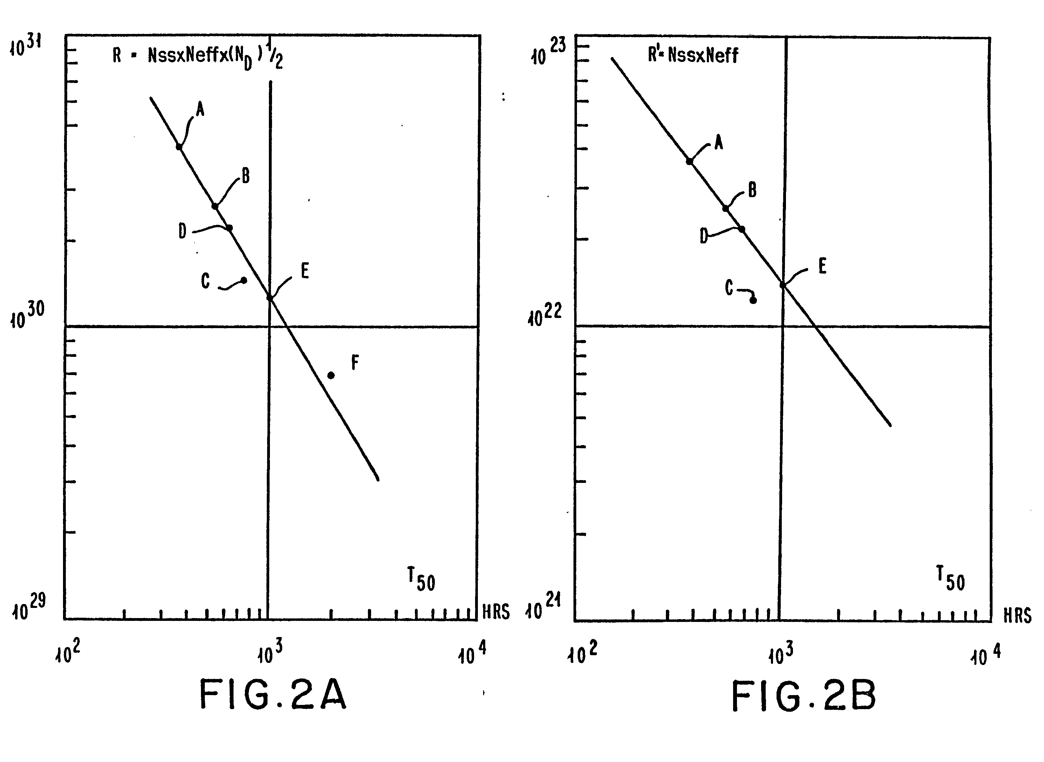

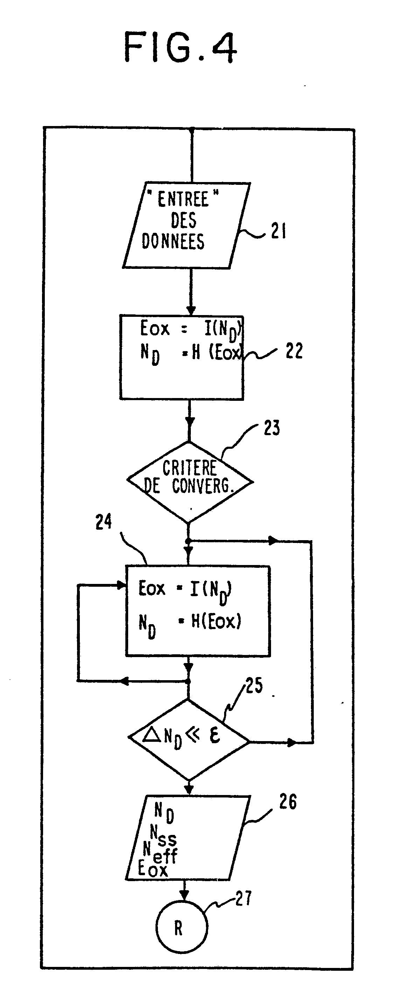

Ensuite les tranches ont subi les étapes de vieillissement en étuve qui ont été détaillées ci-dessus et on a mesuré le $T_{50}$ pour chacun de ces lots. On a reporté sur la figure 2A en ordonnée, le produit de la fonction fiabilité $R = N_{SS} \times N_{eff} \times N_D^{1/2}$ et en abscisse les différents temps de défaillance $T_{50}$. On se rend compte de l'excellente corrélation qui existe entre la fonction fiabilité et les résultats en fiabilité, qui est clairement mise en évidence par la courbe de la figure 2A.

La figure 2B montre une fonction fiabilité $R' = N_{SS} \times N_{eff}$ qui ne tient compte que du phénomène de piégeage des charges et donc ne fait pas intervenir le niveau de dopage de l'épitaxie ($N_D$); cette fonction fournit des résultats légèrement inférieurs, en particulier pour le lot C.

## III. Model de Calcul des Paramètres Prépondérants

Pour obtenir une caractérisation complète de l'oxyde, deux séries de mesures ont été effectuées. Elles concernent les courbes $I_D - V_G$ respectivement en faible inversion et en forte inversion.

a) en faible inversion: détermination de $N_{SS}$

On mesure le $V_T$ du transistor FET de test montré sur la figure 1B et on le polarise à une tension légèrement inférieure (par exemple de deux volts). Les équations qui décrivent le comportement du FET, en inversion faible sont connues dans la littérature, on pourra notamment se référer à l'article:

4

**0 077 862**

"Inadequacy of the Classical Theory of the MOS Transistor Under Weak Inversion" par R. J. Van Overstraeten et al., IEEE Trans. On Electron Devices, Vol. ED20, décembre 1973.

Si on appelle $\eta$ la pente de la courbe $I_D - V_G$ telle que

$$\eta = \frac{d(\text{Log } I_D)}{dV_G}, \text{ on déduit de cet article}$$

$$\eta = \frac{\dfrac{q}{KT} \cdot C_{ox}}{C_{ox} + C_{si} + C_{ss}} \qquad (1)$$

expression dans laquelle $C_{ox}$ est la capacité équivalente de l'oxyde, $C_{ss}$ la capacité d'interface qui est reliée à la densité des états d'interface $N_{ss}$ par la relation:

$$C_{ss} = q N_{ss} \text{ (par unité de surface)} \qquad (2)$$

et $C_{si}$ est la capacité d'interface quand le FET est en inversion.

En combinant (1) et (2) on élimine $C_{SS}$ et on obtient:

$$N_{ss} = \frac{C_{ox}}{\eta kT} - \frac{1}{q}(C_{ox} + C_{si}) \qquad (3)$$

dans cette expression $\eta$ (valeur mesurée de la pente), k, q et T sont connus $C_{ox}$ est directement liée à $E_{ox}$ l'épaisseur équivalente de l'oxyde, et $C_{si}$ est directement liée à la concentration de surface de la couche épitaxiale $N_D$. Soit:

$$N_{ss} = \frac{\varepsilon_{ox}}{\eta E_{ox} kT} - \left\{ \frac{1}{q} \left( \frac{\varepsilon_{ox}}{E_{ox}} + \frac{U_S}{|U_S|} \cdot \frac{\sqrt{\varepsilon_{si}} \cdot \sqrt{q N_D \beta} \cdot N_D}{2\sqrt{2n_i} \sqrt{(\text{Log } N_D/n_i)^{-1}}} \right) \right\} \qquad (4)$$

avec $n_i$ = la concentration intrinsèque du silicium et $U_S$ = le potentiel de surface en d'autres termes:

$$N_{ss} = F(E_{ox}, N_D) \qquad (5)$$

$E_{ox}$ et $N_D$ seront calculés à partir des courbes $I_D - V_G$ en saturation.

On parle de capacité équivalente d'oxyde $C_{ox}$ et d'épaisseur équivalente d'oxyde $E_{ox}$, dans le cas où la couche de passivation ne serait pas une simple couche de $SiO_2$ mais par exemple une couche composite $SiO_2/Si_3N_4/SiO_2$.

b) en forte inversion et en saturation

On polarise le FET de telle sorte qu'il soit en forte inversion, et donc en saturation. Les équations qui régissent le comportent du FET dans ces conditions peuvent être trouvées dans la référence suivante: N.A.T.O.: "Advanced Study Institute for IC Design" 19—29 juillet 1977 F. M. Klaasen—Review of Physical Models for MOS Transistor. Publié par l'Université Catholique de Louvain. La tension de seuil $V_T$ en saturation $V_{TS}$ est fournie par la relation:

$$V_{TS} = V_S + 2\phi_F + \phi_{ms} - \frac{Q_{ox}}{C_{ox}} - k\sqrt{(-V_S - 2\phi_F)} \qquad (6)$$

expression dans laquelle $V_S$ est le potentiel de la région source, $\phi_F$ le potentiel de Fermi à l'équilibre, $\phi_{ms}$ le travail de sortie métal-silicium, $Q_{ox}$ la charge équivalente de l'oxyde et k un coefficient connu tel que:

$$k = \frac{\sqrt{2q\varepsilon_{si}N_D}}{C_{ox}} \qquad (7)$$

où $\varepsilon_{si}$ est la permittivité du silicium.

5

En effectuant deux mesures de la tension de seuil $V_{TS1}$ et $V_{TS2}$ correspondants à deux polarisations de source différentes $V_{S1}$ et $V_{S2}$ déterminées, et en effectuant $V_{TS2}-V_{TS1}$ on aboutit au calcul de k soit:

$$k = \frac{(V_{TS2}-V_{TS1})\ (V_{S2}-V_{S1})}{\sqrt{(-V_{S1}-2\phi_F)} - \sqrt{(-V_{S2}-2\phi_F)}}$$

Ensuite on tire $Q_{ox}$ de (6) sachant que $Q_{ox}=qN_{eff}$ d'où

$$N_{eff}=C_{ox}/q(V_{S1}+2\phi_F+Q_{ms}-V_{TS1}-k\sqrt{(-V_{S1}-2\phi_F)}) \qquad (8)$$

$N_{eff}$ est une fonction de $E_{ox}$ (à travers $C_{ox}$) et de $N_D$ (à travers k), on peut donc écrire:

$$N_{eff}=G(E_{ox},\ N_D) \qquad (9)$$

Or on sait que d'après (7):

$$k = \frac{\sqrt{2q\varepsilon_{si}N_D}}{C_{ox}} \quad \text{d'où} \quad N_D = \frac{k^2 C_{ox}^2}{2q\varepsilon_S} \qquad (10)$$

$$\text{soit } N_D = H(E_{ox}) \qquad (11)$$

On remarque que $N_D$ est un paramètre du procédé et qu'il est en principe connu d'après la spécification. Cette mesure a seulement pour objet une détermination plus précise.

Le problème consiste à déterminer $E_{ox}$. L'épaisseur équivalente de l'oxyde $E_{ox}$ est calculée à partir de la pente $s^2$ de la courbe $I_D-V_G$ en saturation, c'est-à-dire à partir de $I_D=s^2\ (V_G-V_T)^2$. On sait d'après les enseignements de la référence Klaasen que:

$$s^2 = \frac{\beta}{2(\gamma+1)} \qquad (12)$$

avec

$$\beta = \frac{\mu_p\varepsilon_{ox}W}{E_{ox}(L-l)} \qquad (13)$$

et

$$\gamma = \frac{k}{2\sqrt{(-V_s-2\phi_F)}} = \frac{\sqrt{2q\varepsilon_{si}N_D}}{\varepsilon_{ox}} \cdot E_{ox} \qquad (14)$$

Expressions dans lesquelles $\varepsilon_{ox}$ est la permittivité de l'oxyde, $\varepsilon_{si}$ représente la permittivité du silicium, $\mu_p$ la mobilité des trous, W et L représentent respectivement la largeur et la longueur du dispositif FET (voir figure 1B).

Les grandeurs W et L sont déterminées à partir d'une mesure optique, et l est déterminée par le calcul.

Des équations (12), (13), et (14) on tire la valeur de $E_{ox}$

$$E_{ox} = \frac{E_{ox}}{2\sqrt{2q\varepsilon_{si}N_D}} \left[ -1+\sqrt{1+\frac{2\mu_p\sqrt{2q\varepsilon_{si}N_D}W}{s2(L-l)}} \right] \qquad (15)$$

c'est-à-dire $E_{ox}$ en fonction de $N_D$ soit:

$$E_{ox}=I(N_D) \qquad (16)$$

En résumé des caractéristiques $I_D-V_G$ en saturation on a obtenu deux équations, l'une à partir des mesures de tension de seuil en saturation qui fournit:

$$N_D=H(E_{ox}) \qquad (11)$$

et l'autre à partir de la mesure de la pente, qui fournit:

$$E_{ox}=I(N_D) \qquad (16)$$

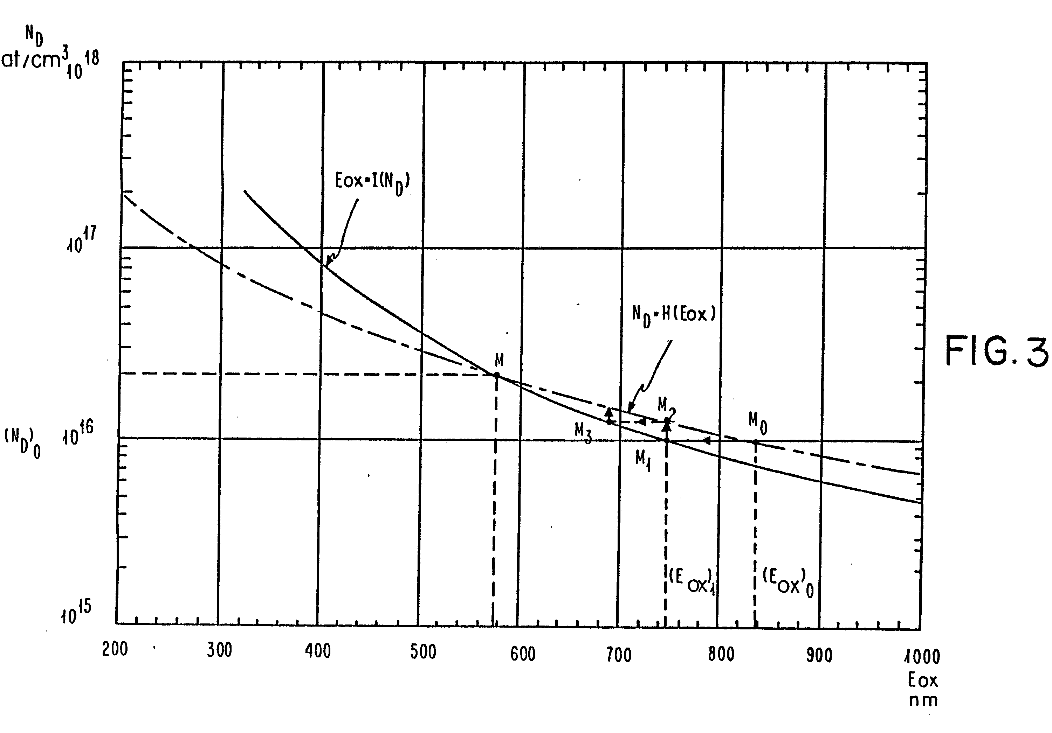

La figure 3 montre dans un cas particulier réel, la forme de ces courbes, l'intersection des courbes H et I fournit les solutions $E_{ox}$ et $N_D$ (dans le cas montré sur la figure 3, on trouve $E_{ox} \neq 570$ nm et $N_D \neq 2,210^{16}$ atomes/cm$^3$. Les valeurs trouvées pour $E_{ox}$ et $N_D$ sont reportées dans l'équation (8), d'où la détermination de $N_{eff}$, et dans l'équation (4) pour la détermination de $N_{SS}$.

Le bloc diagramme du calcul des paramètres prépondérants de la fonction fiabilité R, c'est-à-dire $N_{eff}$, $N_D$ et $N_{SS}$ est montré sur la figure 4. La présence du bloc 21 signifie que toutes les données de départ qui résultent des mesures directes tant électriques ($V_{TS1}$, $V_{TS2}$, $V_{S1}$, $V_{S2}$, $\eta$, s...) qu'optiques (W, L) sont élaborées pour constituer la base de données de travail. Dans le bloc 22, on élabore les fonctions $E_{ox}=I(N_D)$ et $N_D=H(E_{ox})$. Puis on cherche par itération successive à approcher les valeurs $N_D$ et $E_{ox}$ qui correspondent aux coordonnées du point M (figure 3). Pour cela, on utilise la valeur $N_{Do}$ fournie par les instructions de fabrication, qui fournit une valeur approchée de $N_D$, en utilisant la courbe $N_D=H(E_{ox})$, on trouve le point MO qui fournit la valeur $(E_{ox})_o$, qui à son tour fournit M1. On s'assure préalablement de la convergence des points MO, M1,..., vers le point M. C'est le rôle du bloc 23. Dans le bloc 24 le calcul des itérations successives MO, M1, M2,..., $M_n$ es poursuivi, jusqu'à ce que la précision désirée soit atteinte (bloc 25). Les résultats, c'est-à-dire les valeurs $N_D$, $N_{SS}$, $N_{eff}$ et $E_{ox}$ sont disponibles dans le bloc 26, et la valeur de la fonction fiabilité R dans le bloc 27. Le bloc diagramme représenté sur la figure 4 peut servir de base à la mise en œuvre d'un programme-informatique.

IV. Application Industrielle

Sur le plan industriel, le procédé de caractérisation s'implémente de la façon suivante:

On étalonne d'abord une ligne de fabrication donnée en calculant la fonction R pour deux (ou plus) lots différents de tranches et on détermine après étuvage les temps de défaillance $T_{50}$ correspondants. On trace la courbe $R=f(T_{50})$. Ensuite pour un lot déterminé il suffit de calculer sa fonction fiabilité R1 et de déduire directement de la courbe $R=f(T_{50})$, son temps de défaillance $(T_{50})_1$ correspondant, évitant ainsi les opérations complexes et longues d'étuvage.

Ce procédé présente donc un intérêt considérable à la fois pour les lignes pilotes utilisées pour faire du développement de technologie, car il fait gagner un temps précieux pour le développement d'un nouveau produit semi-conducteur, et pour les lignes de fabrication, car il permet une réaction rapide en cas d'apparition d'un défaut en fiabilité, son étude d'abord puis sa correction. Il en résulte une réduction significative de la quantité des tranches défectueuses fabriquées.

Par exemple avec ce procédé de caractérisation on a pu mettre très rapidement en évidence des défauts d'auto-dopage des régions P ou encore des défauts d'alignement des régions d'isolement de type P supérieures. On encore que l'étape classique de recuit, 400°C, 25 minutes effectuée après la formation des conducteurs d'aluminium, en fin de procédé n'était bénéfique que si elle était réalisée dans une atmosphère d'hydrogène. En effet, on a trouvé les résultats suivants:

| | $N_{eff}$ | $N_{SS}$ | $N_D$ | $E_{ox}$ nm |
|---|---|---|---|---|
| Recuit standard | $1,8 \ 10^{11}$ | $7,2 \ 10^{10}$ | $9,5 \ 10^{15}$ | 750 |
| Recuit en $H_2$ | $1,4 \ 10^{11}$ | $5,5 \ 10^{10}$ | $9 \ \ 10^{15}$ | 780 |

Le produit standard correspondait pratiquement au lot C de la figure 2A alors que le produit après recuit en hydrogène est référence en F sur cette même figure, et présente un $T_{50}$ de 2000 heures. Cette amélioration a donc été détectée immédiatement, le calcul de la fonction fiabilité s'effectuant rapidement à l'aide de la technique de calcul décrite ci-après (partie III et figure 4). Cette variante à l'étape de recuit a pu être mise en place aussitôt en ligne de fabrication.

**Revendications**

1. Procédé de détermination du temps de défaillance T de microplaquettes comportant une couche épitaxiale et intégrant des dispositifs semiconducteurs bipolaires susceptibles de présenter des défauts résultant d'instabilités dans la couche d'oxyde de passivation desdits dispositifs et au moins une structure de test de type IGFET, produites par une ligne de fabrication et en particulier du $T_{50}$ qui correspond au temps d'étuvage nécessaire pour que 50% des microplaquettes soient rendues défectueuses caractérisé en ce qu'il comporte les étapes de:

— étalonnage préalable de la ligne de fabrication qui consiste dans:

la sélection de différents lots de microplaquettes produites par la ligne de fabrication;
la mesure pour chaque lot sur la structure de test des coefficients $N_{SS}$ (densité de charges d'interface), $N_{eff}$ (charge équivalente de l'oxyde de passivation) et $N_D$ (concentration de la couche epitaxiale);
le calcul pour chaque lot de la valeur d'une fonction fiabilité R définie comme étant égale au produit

$N_{SS}$ $N_{eff}$ $N_D^{1/2}$ et détermination pour chaque lot du temps de défaillance T, par exemple le $T_{50}$ correspondant;

l'élaboration de la courbe R=f(T) par exemple R=f($T_{50}$) caractéristique de la ligne de fabrication, et

— détermination du temps de défaillance T d'une microplaquette quelconque produite par ladite ligne de fabrication qui consiste dans:

la mesure sur la structure de test de cette microplaquette, des coefficients $N_{SS}$, $N_{eff}$ et $N_D$ précédemment définis;

le calcul de la valeur de la fonction fiabilité R pour cette microplaquette, et

la détermination du temps de défaillance T, par exemple le $T_{50}$ correspondant à cette valeur par lecture directe de la valeur correspondante sur la courbe R=f(T) élaborée précédemment.

2. Procédé selon la revendication 1 caractérisé en ce que la fonction fiabilité R est remplacée par la fonction fiabilité R'=$N_{SS} \cdot N_{eff}$.

3. Procédé selon l'une des revendications 1 ou 2 caractérisé en ce que ladite structure de test est un transistor FET, est réalisée à partir d'un transistor PNP parasite disposé entre la région d'isolation et la région base d'un transistor NPN vertical isolé classique (figure 1B).

## Patentansprüche

1. Verfahren für die Ermittlung der Ausfallzeit T von Mikroplättchen mit einer epitaxialen Schicht, zweipolige Halbleitervorrichtungen enthaltend, die Fehler aufweisen können, aufgrund von Unstabilitäten in der Passivierungs-Oxydschicht der besagten Vorrichtungen, und mindestens eine Teststruktur vom Typ IGFET, erzeugt in einer Fertigungsanlage, und insbesondere der Zeit $T_{50}$, die der Trockenzeit entspricht, die notwendig ist, um 50% der Mikroplättchen defekt zu machen, dadurch gekennzeichnet, dass das Verfahren folgende Etappen enthält:

— vorherige Eichung der Fertigungsanlage, bestehend aus:

der Auswahl der verschiedenen Mikroplättchenlose, die in der Fertigungsanlage erzeugt werden;
die Messung der Beiwerte $N_{SS}$ (Dichte der Schnittstellenladungen), $N_{eff}$ (äquivalente Ladung des Passivierungsoxyds) und $N_D$ (Konzentrierung der epitaxialen Schicht) an jedem Los auf der Teststruktur;
Berechnung des Wertes einer Zuverlässigkeitsfunktion R für jedes Los, die als gleich dem Produkt $N_{SS}$ $N_{eff}$ $N_D^{1/2}$ definiert ist, und Ermittlung der Ausfallzeit T, zum Beispiel der entsprechenden $T_{50}$ für jedes Los.
Erstellung der für die Fertigungsanlage charakteristischen Kurve R=f(T), zum Beispiel R=f($T_{50}$), und

— Ermittlung der Ausfallzeit T eines beliebigen Mikroplättchens, das in der besagten Fertigungsanlage erzeugt wird, bestehend aus:

der Messung auf der Teststruktur dieses Mikroplättchens der oben definierten Koeffizienten $N_{SS}$, $N_{eff}$ und $N_D$;
der Berechnung des Wertes der Zuverlässigkeitsfunktion R für dieses Mikroplättchen, und
der Ermittlung der Ausfallzeit T, zum Beispiel der $T_{50}$, für diesen Wert durch direkte Ablesung des entsprechenden Wertes auf der oben erzeugten Kurve R=f(T).

2. Verfahren gemäss Anspruch 1, dadurch gekennzeichnet, dass die Zuverlässigkeitsfunktion R ersetzt wird durch die Zuverlässigkeitsfunktion R'=$N_{SS} \cdot N_{eff}$.

3. Verfahren nach einem der Ansprüche 1 oder 2, dadurch gekennzeichnet, dass die besagte Teststruktur ein FET-Transistor ist, hergestellt mit Hilfe eines Störtransistors PNP, der zwischen der Isolierungszone und der Basiszone eines herkömmlichen vertikalen isolierten NPN-Transistors angeordnet ist (Abbildung 1B).

## Claims

1. A method of determining the time-to-fail T of chips having an epitaxial layer and integrating bipolar semiconductor devices likely to have defects resulting from instabilities in the passivation oxide layer of said devices, and at least one IGFET type test structure, which are produced on a manufacturing line, and more particularly, of determining the corresponding burn-in time $T_{50}$ necessary for 50% chips to be made deficient, characterized in that it includes the steps of:

— previous elaboration of the manufacturing line which consists in:

selecting a plurality of chip batches produced on the manufacturing line;
computing for each batch from the test structure, coefficients $N_{SS}$ (interface charge density), $N_{eff}$ (equivalent passivation oxide charge) and $N_D$ (impurity concentration in the epitaxial layer);
calculating, for each batch, the value of a reliability function R defined as being equal to the product $N_{SS}$

$N_{eff} N_D^{1/2}$ and determining for each batch the time-to-fail T such as, for instance, the corresponding time $T_{50}$;

plotting curve R=f(T), R=f($T_{50}$), for instance, the characteristic of the manufacturing line, and

— determining the time-to-fail time T of any chip produced on said manufacturing line, which consists in:

computing the previously defined coefficients $N_{SS}$, $N_{eff}$ and $N_D$ on the test structure of said chip; calculating the value of the reliability function R for said chip, and determining the time-to-fail T, $T_{50}$, for instance, corresponding to said value through a direct reading of the corresponding value on the previously plotted curve R=f(T).

2. A method according to claim 1, characterized in that the reliability function R is replaced by the reliability function $R'=N_{SS} \cdot N_{eff}$.

3. A method according to claim 1 or 2, characterized in that said test structure is a FET transistor implemented from a parasitic PNP transistor arranged between the isolation region and the base region of a conventional isolated vertical NPN transistor (figure 1B).

# FIG. 1A

# FIG. 1 B

1

FIG.2A

FIG.2B

# FIG.4

"ENTREE" DES DONNEES — 21

$E_{ox} = I(N_D)$
$N_D = H(E_{ox})$ — 22

CRITERE DE CONVERG. — 23

24 —
$E_{ox} = I(N_D)$
$N_D = H(E_{ox})$

$\triangle N_D \ll \varepsilon$ — 25

$N_D$
$N_{ss}$
$N_{eff}$
$E_{ox}$ — 26

R — 27

FIG.3